# EUROPÄISCHE PATENTSCHRIFT

(11) **EP 1 965 617 B1**
(45) Veröffentlichungstag und Bekanntmachung des Hinweises auf die Patenterteilung: **19.09.2012**
(21) Anmeldenummer: 08003560.3
(22) Anmeldetag: 27.02.2008
(51) Int. Cl.: H05K 3/20, H01L 23/31, H01L 23/495, H01L 21/48

(54) **Verfahren zum Ummanteln von mehreren Stanzgittern**
Method for encapsulting multiple lead frames
Procédé destiné à enrober plusieurs grilles de connexion

(30) Priorität: 28.02.2007 DE 102007009671
(43) Veröffentlichungstag der Anmeldung: 03.09.2008
(73) Patentinhaber: Hirschmann Automotive GmbH, 6830 Rankweil-Brederis (AT)
(72) Erfinder: Brand, Manuel, 6800 Feldkirch (AT); Peter, Gerhard, 6832 Sulz (AT)
(74) Vertreter: Greif, Thomas

(56) Entgegenhaltungen:
- DE-A1- 2 951 063
- DE-A1- 3 622 223
- US-A- 3 983 458
- US-A- 4 183 135
- US-A- 5 512 154
- US-A1- 2005 161 251
- US-A1- 2005 205 970

## Beschreibung

Die Erfindung betrifft ein Verfahren zum Ummanteln von mehreren Stanzgittern gemäß den Merkmalen des Oberbegriffes des Patentanspruches 1.

Aus der EP 0 891 124 A2 sind mehrere Stanzgitter bekannt, die mit mechanischen, elektrischen oder elektronischen Bauteilen verbunden werden, wobei die Stanzgitter von einer Ummantelung aus einem Kunststoffmaterial umgeben sind. Dabei sind die Verbindungsstellen zu den Bauteilen frei, während die übrigen Bereiche der Stanzgitter von Kunststoffmaterial umgeben sind.

Aus der DE 29 51 063 A1 ist ein gattungsgemäßes Verfahren zum Ummanteln von mehreren Stanzgittern, die mit mechanischen, elektrischen, oder elektronischen Bauteilen verbunden werden, wobei die die Stanzgitter von einer Ummantelung aus einem Kunststoffmaterial umgeben werden, bekannt, wobei die Ummantelung ohne ein Formwerkzeug um die Stanzgitter herum aufgebracht wird.

Außerdem ist es bekannt, dass ein Stanzgitter (Leadframe), bestückt mit elektrischen und mechanischen Bauteilen, mit einem isolierenden Material ummantelt und die einzelnen Segmente miteinander verbunden werden müssen. Nach dem Verbinden wird der Leadframe aus den Anbindungen freigestanzt. Dabei ist es bekannt, dass elektrische, elektronische und/oder mechanische Bauteile auf dem Leadframe bestückt werden, dann elektrisch und mechanisch kontaktiert und anschließend umspritzt oder vergossen werden. Danach ist eine Freistanzung erforderlich. Das Umspritzen oder Vergießen erfolgt in entsprechenden Formen (Werkzeuge), so dass der Nachteil besteht, dass die Kosten für die Formen (Werkzeuge) hoch sind und sich dieses bekannte Verfahren für geringe Stückzahlen nicht eignet. Außerdem kann es von Nachteil sein, dass beim Umspritzen mit Kunststoffmaterial, was eine sehr hohe Temperatur hat, zu Bauteilbelastungen und im schlimmsten Falle zu einem Funktionsausfall kommen kann.

Der Erfindung liegt daher die Aufgabe zu Grunde, die eingangs geschilderten Nachteile zu vermeiden. Insbesondere soll ein Verfahren zum Ummanteln von mehreren Stanzgittern bereitgestellt werden, mit dem die Kosten reduziert sind und niedrige Stückzahlen realisiert werden können. Im besten Fall soll auch die Bauteilbelastung durch äußere Einflüsse wie insbesondere sehr hohe Temperaturen reduziert werden.

Diese Aufgabe ist durch die Merkmale des Patentanspruches 1 gelöst.

Erfindungsgemäß wird an den Stellen, an denen ein Bauteil mit dem Stanzgitter kontaktiert werden soll, eine elektrisch leitfähige Verbindungsmasse (wie beispielsweise eine Lotpaste, ein Leitkleber oder dergleichen) aufgebracht, das Bauteil bestückt und anschließend die Ummantelung (beispielsweise ein Schutzkunststoff, aufweisend einen Kleber oder ein Pulver) aufgebracht. Diese gesamte Baugruppe wird einer Erhitzung unterzogen (z.B. in einem Ofen), so dass die beteiligten Bauelemente auf die geforderte Temperatur erhitzt werden. Dabei ist es wesentlich, dass diese geforderte Temperatur zum einen unterhalb der Temperaturen liegt, die bei herkömmlichen Kunststoffspritzgussverfahren mit Formwerkzeugen erforderlich sind, und zum anderen einen solchen Wert annimmt, bei dem die elektrisch leitfähige Verbindungsmasse aufgeschmolzen wird, um die Verbindungsstellen des Bauteils mit den Verbindungsstellen auf dem Stanzgitter unlösbar miteinander zu verbinden. Gleichzeitig mit dem Aufschmelzen der elektrisch leitfähigen Verbindungsmasse erfolgt die Aushärtung des verwendeten Kunststoffmaterials, so dass nach dem Abkühlen das bestückte Stanzgitter fertig ist. Wird ein Leitkleber als elektrisch leitfähige Verbindungsmasse eingesetzt, ist der zusätzliche Vorteil gegeben, dass dessen Aushärtung zeitgleich mit der Aushärtung des umhüllenden Kunststoffmaterials erfolgt.

Außerdem ist vorgesehen, dass die Ummantelung ohne ein Formwerkzeug um die Stanzgitter herum aufgebracht wird. Das Aufbringen des Kunststoffmaterials erfolgt in weiteren Ausgestaltungen der Erfindung z.B. durch Siebdrucken, Schablonendrucken, Dispensen, vorzugsweise Jet-Dispensen, oder durch ein Eintauchen des mit den Bauteilen bestückten Stanzgitters in das flüssige Kunststoffmaterial, wobei abgewartet wird, bis das flüssige Kunststoffmaterial erhärtet ist. Diese Art und Weise der Aufbringung des Kunststoffmaterials auf die Stanzgitter mit den montierten Bauteilen hat den Vorteil, dass ein Formwerkzeug entfallen kann, so dass die Kosten für das Verfahren deutlich geringer sind gegenüber einem Verfahren, bei dem die mehreren Stanzgitter in eine Form eingelegt und mit Kunststoffmaterial umgossen werden. Da das Formwerkzeug entfallen kann, bietet es sich in vorteilhafter Weise an, das erfindungsgemäße Verfahren auch für kleine Stückzahlen einzusetzen. Ein weiterer und wesentlicher Vorteil der Erfindung ist es, dass die Ummantelung mit einem Verfahren aufgebracht wird, bei dem das Kunststoffmaterial gegenüber den bekannten Spritzgussverfahren niedrigere Temperaturen aufweist, so dass die Bauteilbelastung deutlich geringer ist.

Bei dem erfindungsgemäßen Verfahren werden also die erforderlichen Bauteile an den gewünschten Stellen mit den Stanzgittern verlötet, mit einem elektrisch leitfähigen Kleber verklebt oder dergleichen (wie z.B. Schweißen), wobei anschließend dieses derart vorbereitete Teil mit dem Kunststoffmaterial umgeben wird.

Bei den Bauteilen kann es sich um mechanische Bauteile wie z.B. Schnapphaken, Befestigungslaschen oder dergleichen handeln. Sind die Bauteile elektrische Bauteile, so haben sie entweder nur eine elektrische Funktion (wie z.B. eine Drahtbrücke) oder verbinden eine elektrische mit einer mechanischen Funktion wie z.B. Steckkontakte). Alternativ oder ergänzend dazu ist es denkbar, dass es sich um elektronische Bauteile (wie z.B. Widerstände, Kondensatoren, Spulen, integrierte Schaltkreise, Basics oder dergleichen) handelt.

Durch das Siebdrucken, das Schablonendrucken, das Dispensen (insbesondere Jet-Dispensen) oder das Tauchen (wobei auch andere Verfahren denkbar sind, so dass die genannte Aufzählung nicht abschließend ist), mit einem Kleber, einem flüssigen und/oder heißen Kunststoff oder einem Kunststoffpulver, wird das Stanzgitter, das Leadframe, teilweise oder vollständig an den gewünschten Stellen ummantelt. Das Ummanteln des Leadframes kann dabei vor oder nach dem Bestücken der Bauteile erfolgen.

Dieses erfindungsgemäße Verfahren hat den Vorteil, dass drei Funktionen miteinander verbunden werden (Leadframe ummanteln und verbinden sowie Bauteile schützen), die somit in einem Prozess vereint sind. Dadurch ist kein Formwerkzeug erforderlich, die Kosten sind deutlich gesenkt, die Bauteilbelastung in Folge höherer Temperaturen ist gesenkt und die Prozesssicherheit ist erhöht. Schließlich lassen sich auch kleine Stückzahlen verfahrensökonomisch mit dem erfindungsgemäßen Verfahren herstellen.

Alternativ zu der Erhitzung der beteiligten Elemente kann auch daran gedacht werden, dass beispielsweise ein heißer und flüssiger Kunststoff aufgebracht wird, der gleichzeitig das Lot oder die Lotpaste schmelzen bzw. den Leitkleber warm aushärten lässt.

Dadurch ist insgesamt der Vorteil gegeben, dass ein Prozess für zwei verschiedene Verfahren möglich ist.

Ausführungsbeispiele nach der Durchführung des erfindungsgemäßen Verfahrens, das zu Stanzgittern (auch Leadframes genannt) führt, sind im Folgenden beschrieben und anhand der Figuren erläutert.

Es zeigen:
- Figuren 1 a bis 1 e:: verschiedene Ausgestaltungen eines einlagigen Leadframes,
- Figur 2:: einen mehrlagigen Leadframe,
- Figuren 3 a und b:: einen Leadframe mit Versteifung bzw. Schutzrahmen.

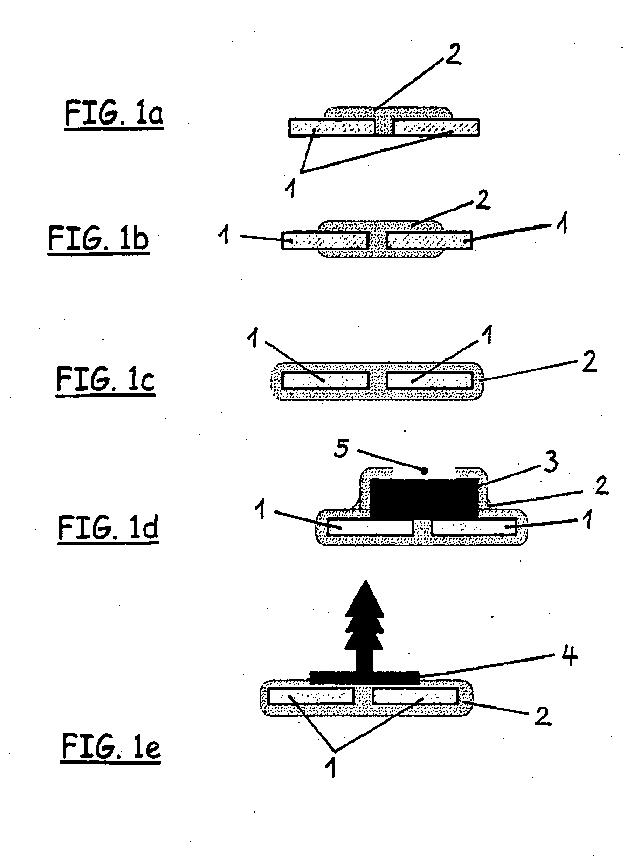

In den Figuren 1 bis 3 ist, soweit im Einzelnen dargestellt, mit der Bezugsziffer 1 ein Stanzgitter (Leadframe) bezeichnet, das von einer Ummantelung aus einem Kunststoffmaterial 2 umgeben ist. In Figur 1 a ist erkennbar, dass zwei Stanzgitter benachbart zueinander angeordnet sind und von dem Kunststoffmaterial 2 einseitig umgeben sind. Figur 1b zeigt eine ähnliche Ausführung, bei der das Kunststoffmaterial 2 die Stanzgitter 1 beidseitig umgibt. Im Gegensatz dazu zeigt Figur 1c, dass die Stanzgitter 1 von dem Kunststoffmaterial 2 vollständig umgeben sind. Figur 1d zeigt ein Bauteil 3 (beispielsweise ein elektronisches Bauteil wie ein Kondensator oder dergleichen), das elektrisch mit den beiden Stanzgittern 1 verbunden ist. Das Bauteil 3 kann vollständig von dem Kunststoffmaterial 2 umgeben sein (Schutzfunktion) oder es kann eine Aussparung 5 verbleiben (um z.B. zu erkennen, um welches Bauteil es sich handelt). Figur 1e zeigt ein mechanisches Bauteil 4 wie z.B. einen Schnapphaken, der keinen Kontakt mit dem Stanzgitter 1 hat und nur von dem Kunststoffmaterial 2 gehalten wird. Das mechanische Bauteil 4 wird entweder bei dem Aufbringen des Kunststoffmaterials 2 von diesem mit umgeben und somit befestigt oder es kann auch nachträglich befestigt werden (z.B. durch Kleben). Damit ist in den Figuren 1a bis 1e die einfachste Form eines einlagigen Leadframes (Monolayer) gezeigt, der für die Realisierung von einfachen elektrischen oder elektronischen Schaltungen und damit für Kleinserien oft ausreichend ist.

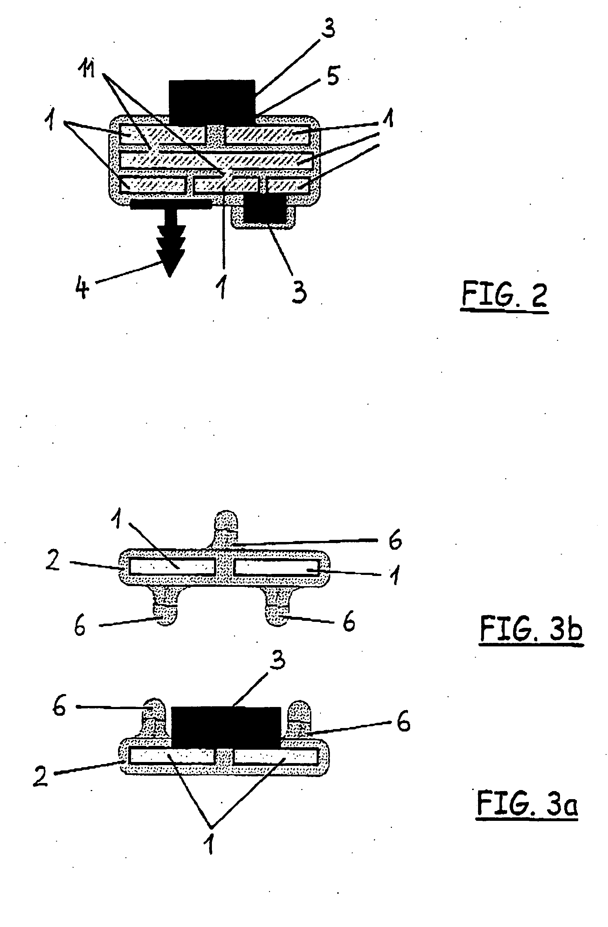

Figur 2 zeigt die beispielhafte Ausführung eines mehrlagigen Leadframes (Multilayer), wobei mehrere Stanzgitter 1 vorhanden sind, die untereinander entweder verbunden oder voneinander getrennt sind. Auch hier können wieder elektronische Bauteile 3 vorhanden und mit den entsprechenden Stellen eines jeweiligen Stanzgitters 1 verbunden sein. Dabei ist es denkbar, dass das elektronische Bauteil 3 teilweise frei ist oder vollständig von dem Kunststoffmaterial 2 umgeben ist. Ebenso kann auch wieder das zumindest eine mechanische Bauteil 4 vorhanden sein. Die elektrische Verbindung der Stanzgitter untereinander kann durch entsprechende Verbindungstechniken wie Löten, Schweißen, Nieten, anisotope Leitkleber, isotrope Leitkleber oder andere Verbindungstechniken erfolgen. Mit einem solchen Multilayer, der in Figur 2 lediglich beispielhaft dargestellt ist, lassen sich auch aufwändige Schaltungen realisieren.

Figur 3 zeigt Stanzgitter 1 mit umgebendem Kunststoffmaterial 2, wobei in Figur 3 a eine beidseitige Versteifung 6 gegeben ist. Die Versteifung 6 kann auch nur auf einer Seite des Leadframes vorhanden sein. Die ein- oder beidseitige Versteifung 6 hat den Vorteil, dass das ansonsten flächig ausgebildete Gebilde in Längsrichtung versteift wird. Die Versteifungen 6 können, so wie in Figur 3b gezeigt, nicht nur der Versteifung dienen, sondern auch eine Begrenzung (Rahmen) entlang von zumindest zwei Seiten des elektronischen Bauteils 3, insbesondere an allen vier Seiten, bilden, um das nachträgliche Bestücken des Bauteils 3 ausführen zu können und einen Schutz des Bauteils 3 vor äußeren Einflüssen (wie z.B. Stöße) zu bilden. Solche Versteifungen 6 lassen sich z.B. mit hochviskosem Kleber in dreidimensionalen Strukturen aufbringen, genau so wie durch Siebdrucken oder Schablonendrucken in mehreren Schichten, aber auch durch mehrmaliges Dispensen oder Jet-Dispensen.

Insgesamt bietet die Erfindung also damit die Vorteile, dass keine aufwändigen Werkzeuge erforderlich sind, das eine schnelle Realisierbarkeit gegeben ist, dass schnelle Änderungen möglich sind, genau so wie eine hohe Variantenvielfalt. Daneben sind dreidimensionale Anordnungen sowie nahezu jede Elektronikform realisierbar. Mit den Stanzgittern 1 und den übrigen Bauteilen lassen sich Steuersignale genauso übertragen wie hohe Lastströme.

Zum Begriff "Dispensen" noch folgende Erläuterung: Grundsätzlich ist der bloße Umgang mit zähen Flüssigkeiten schwierig. In industriellen Anwendungen sind dies vor allem (zunächst) flüssige (und danach aushärtbare) Kunststoffe, Flussmittel, Klebstoffe, Lacke und Lötpasten. Diese Flüssigkeiten sind hochviskos und enthalten zusätzlich häufig noch Feststoffe, beispielsweise um sie leitfähig zu machen. Die Mikrosystemtechnik stellt besonders hohe Anforderungen, denn beim Dispensen sollen sie auf kleine (Leadframes) und kleinste Bauteile mit einer kleinen Tropfengröße (beispielsweise von wenigen Nanolitem) und sehr genau (beispielsweise auf wenige Mikrometer genau) aufgebracht (dispensen) werden. Berührende Verfahren wie Siebdruck, Stempeln und das Eintauchen der Bauteile erfüllen zwar schon diese Anforderungen hinreichend. Berührungslose Verfahren, bei denen es zu einer vollständigen Ablösung des Tropfens von der Dosierpumpe (Dispenskopf) kommt, sind allerdings noch schonender (gerade bei temperaturempfindlichen Bauteilen) und noch genauer und finden deshalb hier in der Mikrosystemtechnik bei Schaltungsträgern in Form von Leadframes erfindungsgemäß Einsatz. Dispensköpfe für insbesondere hochviskose Flüssigkeiten stoßen die Flüssigkeit aus einer Mikrodüse aus. Außerhalb der Düse schnürt sich die Flüssigkeit auf Grund der Oberflächenspannung ein und bildet einen fliegenden Tropfen mit definierter Geschwindigkeit. Der Rest zieht sich zurück und benetzt bei hohen Viskositäten den Dispenskopf. Ob die Einrichtung dann noch funktionsfähig ist, hängt von der Größe dieses Meniskus ab, der von der Oberflächenspannung und vor allem von der Viskosität beeinflusst wird. Diese Parameter lassen sich über die Temperatur steuern.

## Patentansprüche

1. Verfahren zum Ummanteln von mehreren Stanzgittern, die mit mechanischen, elektrischen, oder elektronischen Bauteilen verbunden werden, wobei die Stanzgitter von einer Ummantelung aus einem Kunststoffmaterial umgeben werden, wobei die Ummantelung ohne ein Formwerkzeug um die Stanzgitter herum aufgebracht wird, wobei an den Stellen, an denen ein Bauteil mit dem Stanzgitter kontaktiert werden soll, eine elektrisch leitfähige Verbindungsmasse aufgebracht wird, das Bauteil bestückt und anschließend die Ummantelung aufgebracht wird, wobei eine Erhitzung durchgeführt wird **dadurch gekennzeichnet, dass** die Erhitzung über das auf eine vorgebbare Temperatur erhitzte Kunststoffmaterial erfolgt.

2. Verfahren nach Anspruch 1, **dadurch gekennzeichnet, dass** die Ummantelung durch Siebdruck aufgebracht wird.

3. Verfahren nach Anspruch 1, **dadurch gekennzeichnet, dass** die Ummantelung durch Schablonendruck aufgebracht wird.

4. Verfahren nach Anspruch 1, **dadurch gekennzeichnet, dass** die Ummantelung durch Dispensen, insbesondere Jet-Dispensen, aufgebracht wird.

5. Verfahren nach Anspruch 1, **dadurch gekennzeichnet, dass** die Ummantelung durch Eintauchen in das flüssige Kunststoffmaterial aufgebracht und abgewartet wird, bis das flüssige Kunststoffmaterial erhärtet ist.

6. Verfahren nach einem der vorhergehenden Ansprüche, **dadurch gekennzeichnet, dass** aus dem Kunststoffmaterial zumindest eine Versteifung gebildet wird.

## Claims

1. Method for encapsulating multiple lead frames that are connected to mechanical, electrical or electronic components, wherein the lead frames are surrounded by an encapsulation of a plastics material, wherein the encapsulation is applied around the lead frames without a mould, wherein an electrically conductive bonding compound is applied at the locations at which a component is intended to be brought into electrical contact with the lead frame, the component is mounted and the encapsulation is subsequently applied, with heating being carried out, **characterized in that** the heating is performed by way of the plastics material heated to a predeterminable temperature.

2. Method according to Claim 1, **characterized in that** the encapsulation is applied by screen printing.

3. Method according to Claim 1, **characterized in that** the encapsulation is applied by stencil printing.

4. Method according to Claim 1, **characterized in that** the encapsulation is applied by dispensing, in particular jet dispensing.

5. Method according to Claim 1, **characterized in that** the encapsulation is applied by immersion in the liquid plastics material and waiting until the liquid plastics material has hardened.

6. Method according to one of the preceding claims, **characterized in that** at least one stiffening is formed from the plastics material.

## Revendications

1. Procédé destiné à envelopper plusieurs grilles estampées reliées à des composants mécaniques, électriques ou électroniques,
les grilles estampées étant englobées dans une enveloppe en matière synthétique,
l'enveloppe étant appliquée sans outil de moulage autour des grilles estampées,
une pâte de liaison électriquement conductrice étant appliquée aux emplacements auxquels un composant doit être mis en contact avec la grille estampée,
le composant étant placé et l'enveloppe étant ensuite appliquée et un chauffage étant réalisé,
**caractérisé en ce que** le chauffage est réalisé par l'intermédiaire de la matière synthétique chauffée à une température prédéterminée.

2. Procédé selon la revendication 1, **caractérisé en ce que** l'enveloppe est appliquée par sérigraphie.

3. Procédé selon la revendication 1, **caractérisé en ce que** l'enveloppe est appliquée par impression au pochoir.

4. Procédé selon la revendication 1, **caractérisé en ce que** l'enveloppe est appliquée par répartition, en particulier répartition par projection.

5. Procédé selon la revendication 1, **caractérisé en ce que** l'enveloppe est appliquée par immersion dans la matière synthétique liquide en attendant que la matière synthétique liquide ait durci.

6. Procédé selon l'une des revendications précédentes, **caractérisé en ce qu'**au moins une rigidification est formée à partir de la matière synthétique.
